# EUROPEAN PATENT APPLICATION

(11) **EP 1 198 015 A2**
(43) Date of publication of application: **17.04.2002**
(21) Application number: 01307817.5
(22) Date of filing: 13.09.2001
(51) Int. Cl.: H01L 31/105, H01L 31/18, H01L 31/0352

(54) **An optoelectronic device doped to augment an optical power threshold for bandwidth collapse and a method of manufacturing therefor**

(30) Priority: 13.09.2000 US 232201
(71) Applicant: Agere Systems Optoelectronics Guardian Corporation, Orlando, Florida 32819-8698 (US)
(72) Inventor: Flynn, Edward J., Summit, New Jersey 07901 (US); Gruezke, Leonard A., Oakhurst, New Jersey 07755, (US); Lang, David V., Madison, New Jersey 07940, (US); Onat, Bora M., Macungie, Pennsylvania 18062 (US); Yoder, P. Douglas, New Providence, New Jersey 07974 (US)
(74) Representative: Perkins, Sarah

(57) **Abstract**

An improved optoelectronic device and a method of manufacture therefor. The optoelectronic device includes a doped buffer layer (320) located over a substrate (310) having an optical window (315) formed therein and an absorber layer (330) located over the doped buffer layer (320). The optoelectronic device further includes a doped region (350) located over the absorber layer (330) and having a dopant tail (355) that extends substantially through the absorber layer (330), and the doped buffer layer (320) and the dopant tail (355) are doped to augment an optical power threshold for bandwidth collapse of the optoelectronic device.

## Description

### TECHNICAL FIELD OF THE INVENTION

The present invention is directed, in general, to optoelectronics and, more specifically, to an optoelectronic device being doped to augment an optical power threshold for bandwidth collapse, and a method of manufacture therefor.

### BACKGROUND OF THE INVENTION

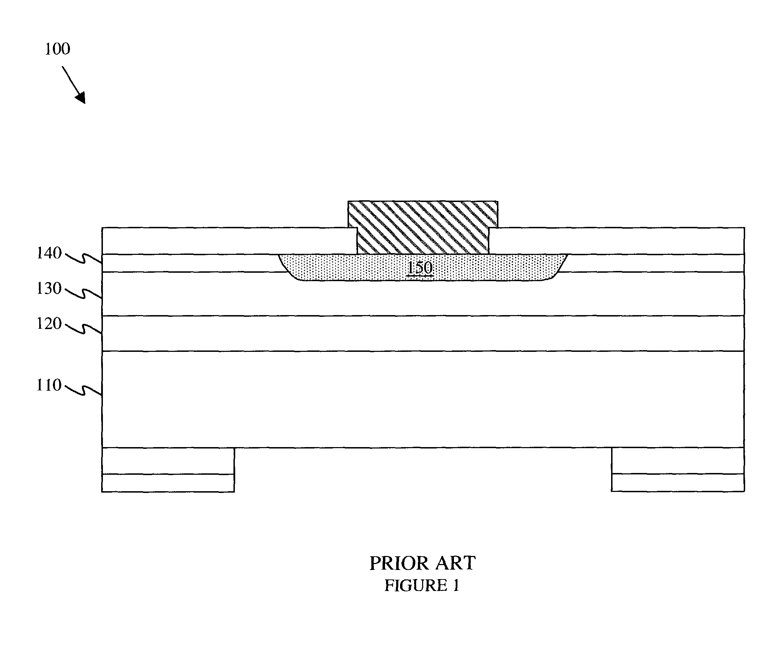

PIN photodetectors are currently widely used in long wavelength (e.g., 1.3 µm to about 1.55 µm) optical receivers for telecommunications systems. An example of a conventional PIN photodetector 100 is illustrated in Prior Art FIGURE 1, and will hereafter be described. The PIN photodetector 100 includes an optical substrate 110 having an undoped indium phosphide (InP) buffer layer 120 located thereon. The PIN photodetector 100 further includes an undoped absorber layer 130 located on the undoped buffer layer 120, and an undoped cap layer 140 located on the undoped absorber layer 130. Located within the undoped cap layer 140 and contacting the undoped absorber layer 130 is a P++ diffusion region 150.

As can be assumed, a p-n junction is created by the formation of the P++ diffusion region 150 through the undoped cap layer 140, and down into the undoped absorber layer 130. When a reverse bias voltage, as is commonly used, is applied to the PIN photodetector 100, an electric field may exist across the undoped absorber layer 130. Photogenerated charge carriers, e.g., electrons and holes, may then move under the influence of this electric field. As a result, an electric current flows, converting an optical excitation into an electrical signal.

It is typically a desire for such PIN photodetectors to exhibit high quantum efficiency, high bandwidth and high optical power threshold, each of which are specifically designed for a chosen baud rate of the system. It is also desirable to minimize the level of bandwidth collapse associated with the PIN photodetectors. High quantum efficiency typically requires a very thick undoped absorber layer 130. However, this thickness requirement not only limits the detector bandwidth, but contributes to bandwidth collapse. This is especially apparent at input power levels intolerably low for some systems. With voltage levels currently decreasing to about 2 volts, the bandwidth and bandwidth collapse problems are more apparent.

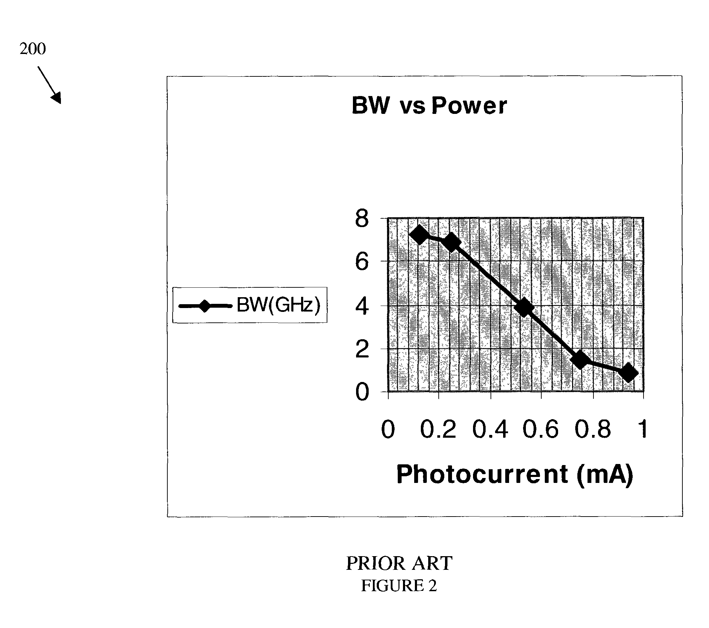

To further elucidate the effects of bandwidth collapse, FIGURE 2 illustrates a graphical representation 200 of a bandwidth versus input current for a device comprising a thick undoped absorber layer 130 with only about 2 volts reverse bias being applied. As is illustrated, the bandwidth collapses to less than about 1 GHz at the high end of the input power range. Thus, the PIN photodetector device, in the current example, is not effective in a 1. 5 GHz to about 2.5 GHz system, wherein the PIN photodetector has to tolerate as much as 0 dBM optical power.

Accordingly, what is needed in the art is an optoelectronic device that exhibits an improved optical power threshold that reduces the deficiencies of the prior art.

### SUMMARY OF THE INVENTION

To address the above-discussed deficiencies of the prior art, the present invention provides an improved optoelectronic device and a method of manufacture therefor. The optoelectronic device includes a doped buffer layer located over a substrate having an optical window formed therein and an absorber layer located over the doped buffer layer. The optoelectronic device further includes a doped region located over the absorber layer and having a dopant tail that extends substantially through the absorber layer, wherein the doped buffer layer and the dopant tail are doped to augment an optical power threshold for bandwidth collapse of the optoelectronic device.

The foregoing has outlined preferred and alternative features of the present invention so that those skilled in the art may better understand the detailed description of the invention that follows. Additional features of the invention will be described hereinafter that form the subject of the claims of the invention. Those skilled in the art should appreciate that they can readily use the disclosed conception and specific embodiment as a basis for designing or modifying other structures for carrying out the same purposes of the present invention. Those skilled in the art should also realize that such equivalent constructions do not depart from the spirit and scope of the invention.

### BRIEF DESCRIPTION OF THE DRAWINGS

The invention is best understood from the following detailed description when read with the accompanying FIGUREs. It is emphasized that in accordance with the standard practice in the optoelectronic industry, various features may not be drawn to scale. In fact, the dimensions of the various features may be arbitrarily increased or reduced for clarity of discussion. Reference is now made to the following descriptions taken in conjunction with the accompanying drawings, in which:
FIGURE 1 illustrates a cross-sectional view of a Prior Art PIN photodetector;
FIGURE 2 illustrates a Prior Art graphical representation demonstrating the effects of bandwidth collapse at high optical power input, associated with a PIN photodetector;
FIGURE 3 illustrates one embodiment of a cross-sectional view of an optoelectronic device, in accordance with the present invention;
FIGURE 4 illustrates a cross-sectional view of a partially completed optoelectronic device;
FIGURE 5 illustrates a cross-sectional view of the partially completed optoelectronic device illustrated in FIGURE 4, after formation of an absorber layer;
FIGURE 6 illustrates a cross-sectional view of the partially completed optoelectronic device illustrated in FIGURE 5, after formation of a cap layer;
FIGURE 7 illustrates a cross-sectional view of the partially completed optoelectronic device illustrated in FIGURE 6, after formation of a doped region;
FIGURE 8 illustrates a scanning capacitance image of a cleaved cross section of the partially completed optoelectronic device illustrated in FIGURE 7;
FIGURE 9 illustrates a cross-sectional view of the partially completed optoelectronic device illustrated in FIGURE 7, after formation of a dielectric layer thereover;
FIGURE 10 illustrates a plot of capacitance of a completed optoelectronic device versus the intentional doping level of an InP buffer layer;
FIGURE 11 illustrates a view of an optical fiber communication system, which may form one environment in which a completed optoelectronic device similar to the completed optoelectronic device illustrated in FIGURE 3, may be used; and
FIGURE 12 illustrates a view of an alternative optical fiber communication system having a repeater.

### DETAILED DESCRIPTION

Optoelectronic devices, and more specifically, planar technology photodetectors, are well known and commonly used in today's high technology field. Although planar technology photodetectors are commonly used, such photodetectors experience certain tradeoffs depending on a thickness of an absorber layer. For example, increasing the thickness of the absorber layer (e.g., to a value greater than about 3000 nm) beneficially increases the quantum efficiency, however, this also detrimentally decreases the photodetector's bandwidth, and contributes to the phenomenon of bandwidth collapse at input power levels intolerably low for some systems.

One inventive aspect of the present invention is the recognition that optoelectronic devices, such as the above mentioned planar technology photodetectors, benefit from having a doped buffer layer and a dopant tail located within the absorber layer. For example, it has been found that by improving the dopant concentrations of the doped buffer layer and absorber layer, a photodetector having an improved bandwidth, bandwidth collapse and optical power threshold properties may be obtained. In addition, the customized doping schemes permit the use of a thicker absorber layer, in effect increasing the photodetector's quantum efficiency, which was not otherwise possible in the prior art. This is generally accomplished while maintaining the optical power threshold for bandwidth collapse at a tolerably high level, typically greater than about 0 dBM. Therefore, in one aspect, the present invention recognizes that the buffer layer and absorber layer may be intentionally doped using various concentrations of various dopants, providing a photodetector having improved properties.

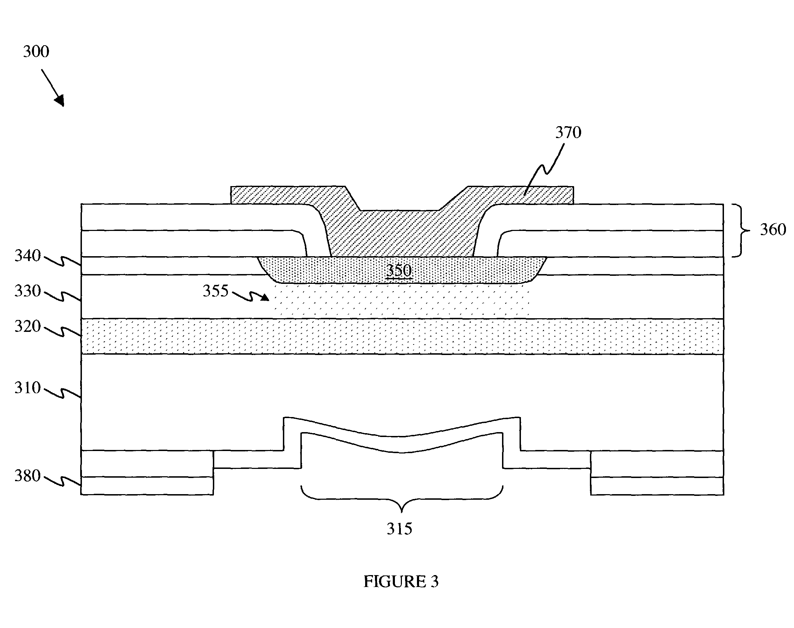

Referring initially to FIGURE 3, illustrated is a cross-sectional view of one embodiment of an optoelectronic device 300, having the beneficial properties discussed above, and in accordance with the teachings of the present invention. The optoelectronic device 300, which may be a planar technology photodetector, initially includes a substrate 310, which in one particular embodiment, has an optical window 315 formed therein. Located over the substrate 310 is a doped buffer layer 320. In the illustrative embodiment shown in FIGURE 3, the doped buffer layer 320 is a doped indium phosphide buffer layer.

Located over the doped buffer layer 320 is an absorber layer 330. The absorber layer 330, in one particular embodiment, is an indium gallium arsenide absorber layer. Located over the absorber layer 330 is a cap layer 340. The cap layer 340 has located therein a doped region 350. As illustrated, the doped region 350 has a dopant tail 355 which extends substantially through the absorber layer 330. This dopant tail 355 helps to provide the beneficial properties discussed above. In the particular embodiment illustrated in FIGURE 3, the doped buffer layer 320 and the dopant tail 355 are doped to augment an optical power threshold for bandwidth collapse of the optoelectronic device 300.

The optoelectronic device 300 illustrated in FIGURE 3 further includes a dielectric layer 360, or in this particular embodiment dielectric layers, located over the cap layer 340. Also, located within an opening in the dielectric layer 360 is a first contact region 370. The first contact region 370, in one particular embodiment, is a P-metal contact. Additionally, located on a bottom surface of the optoelectronic device 300 is a second contact region 380. If the first contact region 370 is a P-metal contact, the second contact region 380 would typically be an N-metal contact, and vice versa. The second contact region 380 may constitute a standard electrode acting as a biasing or electrical connection for the optoelectronic device 300.

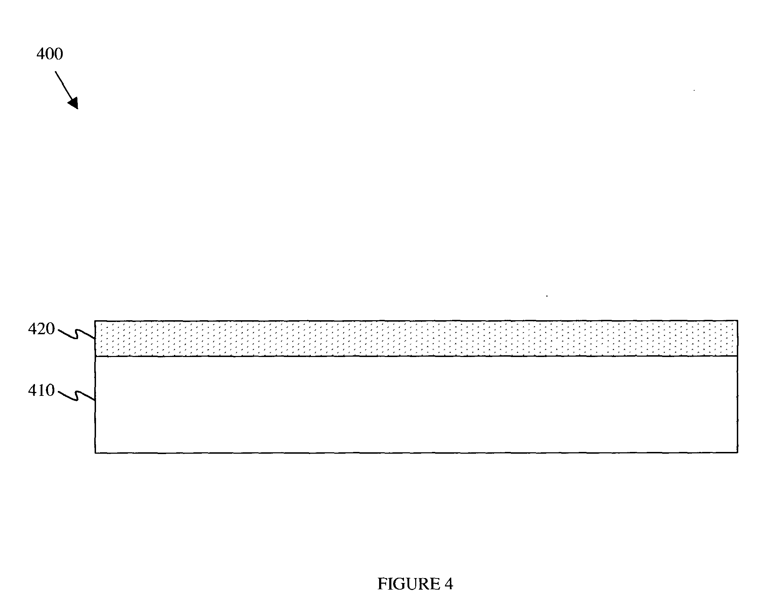

Turning to FIGUREs 4-9, illustrated are cross-sectional views of detailed manufacturing steps instructing how one might, in an advantageous embodiment, manufacture an optoelectronic device similar to the optoelectronic device 300 depicted in FIGURE 3. FIGURE 4 illustrates a cross-sectional view of a partially completed optoelectronic device 400. The partially completed optoelectronic device 400 includes a substrate 410. The substrate 410 may comprise many materials, however, in one particularly advantageous embodiment the substrate 410 comprises indium phosphide. One having skill in the art generally understands how to form the substrate 410. For this reason no further discussion is required.

Formed over the substrate 410 is a doped buffer layer 420. The doped buffer layer 420, such as an indium phosphide or other similar doped buffer layer, includes a primary dopant concentration and a background dopant concentration. In such an embodiment, the primary dopant concentration is intentional, whereas the background dopant concentration results from parasitic dopant atoms encountering the device 400 during manufacture thereof. In contrast to the present invention, prior art optoelectronic devices only include background dopants having a dopant concentration on the order of less than about 5E15 atoms/cm³, if any background dopant concentration exist at all.

The doped buffer layer 420, in an exemplary embodiment, has an N-type dopant concentration of at least about 6E15 atoms/cm³. It should be noted that other dopant concentrations are within the scope of the present invention, however, the doped buffer layer 420 should have a large enough dopant concentration to assure that a field in an associated depletion region is sufficiently large to guarantee a large saturation threshold, thus, providing good overload properties up to about 0 dBM optical power.

One skilled in the art understands how to form the doped buffer layer 420 including depositing the doped buffer layer 420 using a chemical vapor deposition (CVD), or other similar deposition process. One skilled in the art further understands the thickness that the doped buffer layer 420 may be formed to, including a thickness ranging from about 500 nm to about 1500 nm. It should be noted, however, that the thickness of the doped buffer layer 420 is controlled, in part, by the overall requirements of the optoelectronic device 400, including the dopant concentrations of the doped buffer layer 420 and a dopant tail located thereover.

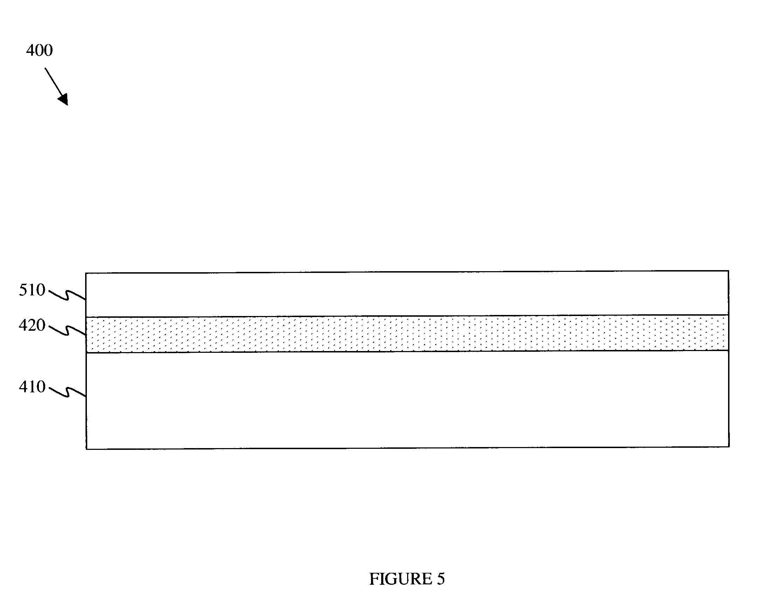

Turning now to FIGURE 5 illustrated is a cross-sectional view of the partially completed optoelectronic device 400 illustrated in FIGURE 4, after formation of an absorber layer 510. As illustrated, the absorber layer 510 may be formed over the doped buffer layer 420. In one particularly advantageous embodiment of the present invention, the absorber layer 510 comprises indium gallium arsenide. It should be noted, however, that any other suitable group III through group V-based absorber layers, or for that matter any other suitable absorber layers, are within the scope of the present invention.

The absorber layer 510 may be manufactured using any compatible formation process, including the previously mentioned CVD process. In the illustrative embodiment shown in FIGURE 5, the absorber layer 510 is formed to a thickness ranging from about 1500 nm to about 3500 nm. Nonetheless, various other absorber layer 510 thicknesses may be used.

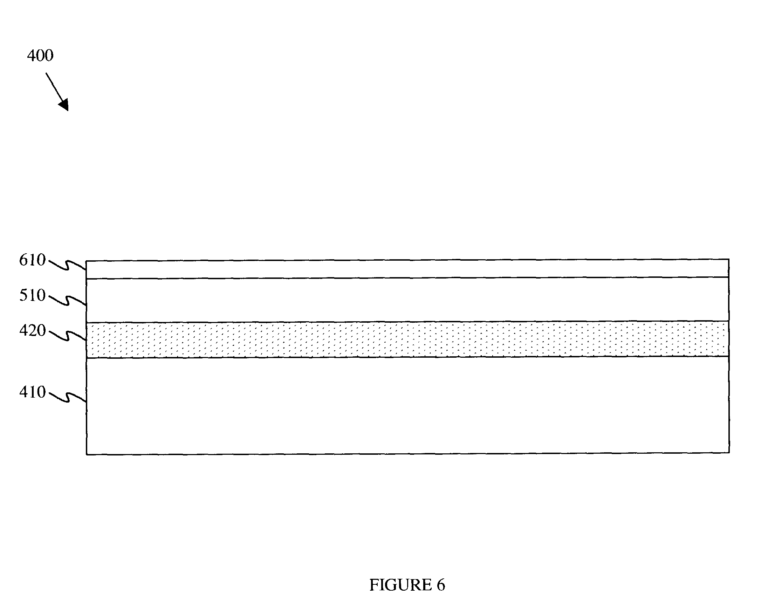

Turning to FIGURE 6, illustrated is a cross-sectional view of the partially completed optoelectronic device 400 illustrated in FIGURE 5, after formation of a cap layer 610. The cap layer 610, which in one embodiment may be a conventional indium gallium arsenide phosphide cap layer having an energy gap of about 1.18 µm and being lightly but not intentionally N-type doped, is located over the absorber layer 510. The cap layer 610 may be conventionally formed, using any currently known or hereafter discovered process.

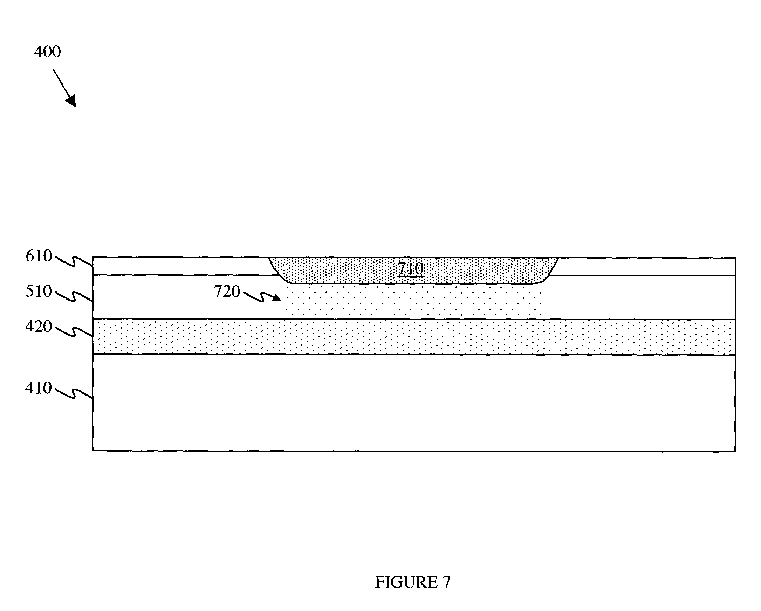

Turning to FIGURE 7, illustrated is a cross-sectional view of the partially completed optoelectronic device 400 illustrated in FIGURE 6, after formation of a doped region 710. In the illustrative embodiment shown in FIGURE 7, the doped region 710 is formed within the cap layer 610. As also shown in FIGURE 7, the doped region 710 includes a dopant tail 720 that extends substantially through the absorber layer 510. The dopant tail 720, in one embodiment, helps reduce the distance that holes travel in the absorber layer 510 during operation, resulting in increased bandwidth.

The doped region 710, in an advantageous embodiment, is doped to a concentration ranging from about 5E17 atoms/cm³ to about 2E18 atoms/cm³. Such dopant concentrations may be important to obtain a dopant concentration of the dopant tail 720, of at least about 5E15 atoms/cm³. It should be noted, however, that the dopant concentrations of the doped region 710 and dopant tail 720, may vary from those just described.

The doped region 710 may be formed using many processes and techniques, however, in one advantageous embodiment a layer of photoresist is formed, patterned and developed over the cap layer 610, and a dopant is subsequently diffused into a portion of the cap layer 610 not protected by the photoresist, resulting in the doped region 710. It has been found that a closed ampoule diffusion process is particularly advantageous for formation of the doped region 710 and dopant tail 720, however, other processes may be used. In one particularly advantageous embodiment, the dopant is a P-type dopant and the doped region 710 is a P-type doped region.

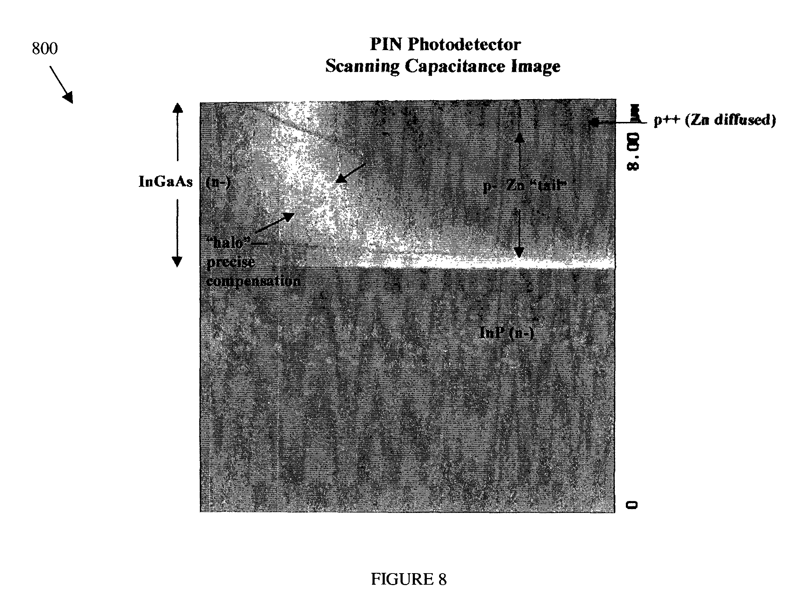

Turning to FIGURE 8, with continued reference to FIGURE 7, illustrated is a scanning capacitance image 800 of a cleaved cross section of one embodiment of the partially completed optoelectronic device 400 illustrated in FIGURE 7. Initially, it should be noted that the positions, doping concentrations, dopant type and layer compositions of the layers illustrated in FIGURE 8 are only representative of one embodiment of the present invention. Take notice of the "tail" (similar to dopant tail 620), and the "halo," which is located at a boundary of the "tail" region. In one embodiment, the "halo" represents where electrical compensation between the "tail" region and absorber layer 510 occurs. Note that the "halo" extends sideways, indicating a lateral metallurgical junction between the "tail" region and the undoped regions within the absorber layer 510.

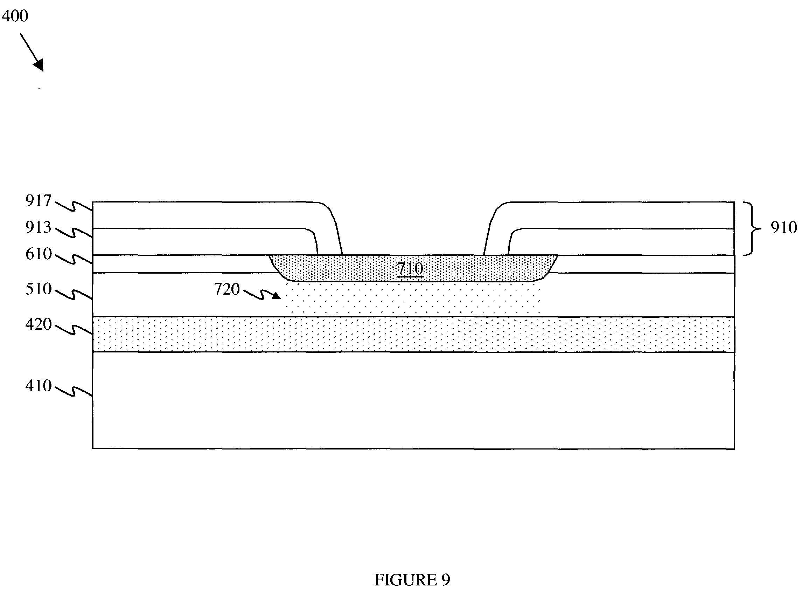

Turning to FIGURE 9, illustrated is a cross-sectional view of the partially completed optoelectronic device 400 illustrated in FIGURE 7, after formation of a dielectric layer 910 thereover. In the particular embodiment illustrated in FIGURE 9, the dielectric layer 910 includes first and second dielectric layers 913, 917, respectively. In the illustrative embodiment, the first dielectric layer 913 comprises silicon nitride and the second dielectric layer 917 comprises silicon dioxide, however, one skilled in the art understands that many other similar materials may be used, and are within the scope of the present invention.

The dielectric layer 910 may be conventionally formed using many known processes. In one instance, the dielectric layer 910 is blanket deposited over the surface of the cap layer 610, a layer of photoresist is deposited, patterned and developed, and an unprotected portion of the dielectric layer 910 is etched, resulting in the structure shown in FIGURE 9. While one embodiment of how to form the dielectric layer 910 has been discussed, one skilled in the art understands many other processes are available. After completion of the dielectric-layer 910, P-type and N-type metal contact layers could be blanket deposited and patterned, as well as an optical window be formed, resulting in a device similar to the completed optoelectronic device 300 illustrated in FIGURE 3.

Without the current attention to buffer layer doping exhibited in the present invention, bandwidth collapse, capacitance and speed can not easily be controlled by design, such as attempted in the prior art. As a result, the present invention does not substantially experience the wafer yield fluctuations experienced by the prior art, which may be up to a factor of three. Additionally, the present invention allows high speed/high power system requirements to be met with much reduced cost, as compared to an extensive screening/testing strategy as used in the prior art. Using such processes, wafer certification up to about 100% may be obtained. The present invention additionally provides an optoelectronic device capable of accurately operating at bias voltages of about -2V and optical input powers up to about 0 dBM. Likewise, capacitances of less than about .75 picofarad may be achieved, providing a more accurate optoelectronic device.

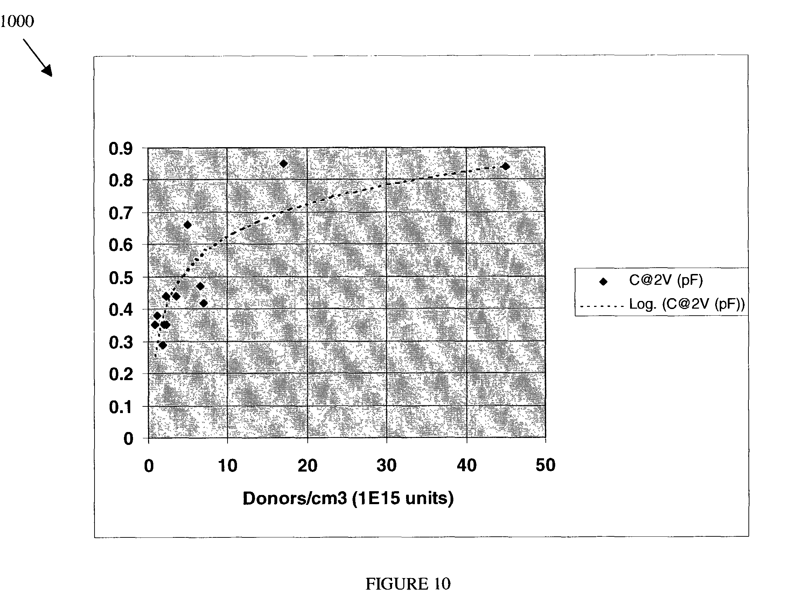

Turning to FIGURE 10, shown is a plot 1000 of capacitance of a completed optoelectronic device versus intentional doping of the buffer layer. As illustrated, the doping concentration may be chosen to capture the advantages of high power operation, but at the same time, limit the increase in capacitance that the doping causes.

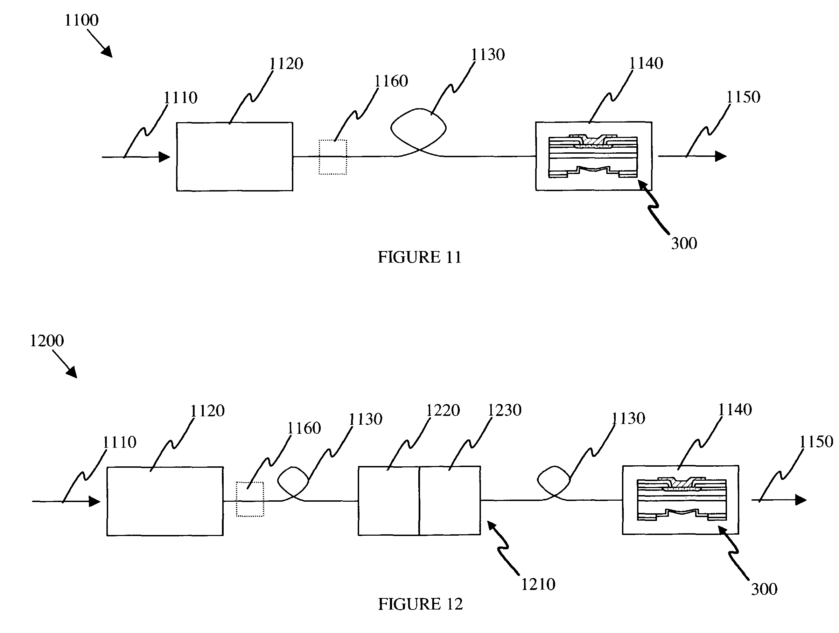

Turning to FIGURE 11, illustrated is a cross-sectional view of an optical fiber communication system 1100, which may form one environment in which a completed optoelectronic device, similar to the completed optoelectronic device 300 illustrated in FIGURE 3, may be used. An initial signal 1110 enters a transmitter 1120 of the optical fiber communications system 1100. The transmitter 1120, receives the initial signal 1110, addresses the signal 1110 and sends the resulting information across an optical fiber 1130 to a receiver 1140. The receiver 1140 receives the information from the optical fiber 1130, addresses the information and sends an output signal 1150. As illustrated in FIGURE 11, an optoelectronic device such as the completed optoelectronic device 300, may be included within the receiver 1140. However, the completed optoelectronic device 300 may also be included anywhere in the optical fiber communication system 1100, including the transmitter 1120. The optical fiber communication system 1100 is not limited to the devices previously mentioned. For example, the optical fiber communication system 1100 may include an element 1160, such as a laser, diode, modulator, optical amplifier, optical waveguide, or other similar device.

Turning briefly to FIGURE 12, illustrated is an alternative optical fiber communication system 1200, having a repeater 1210, including a second transmitter 1220 and a second receiver 1230, located between the transmitter 1120 and the receiver 1140.

Although the present invention has been described in detail, those skilled in the art should understand that they can make various changes, substitutions and alterations herein without departing from the spirit and scope of the invention in its broadest form.

## Claims

1. An optoelectronic device, comprising:
a doped buffer layer located over a substrate having an optical window formed therein;
an absorber layer located over the doped buffer layer; and
a doped region located over the absorber layer and having a dopant tail that extends substantially through the absorber layer, the doped buffer layer and the dopant tail being doped to augment an optical power threshold for bandwidth collapse of the optoelectronic device.

2. The optoelectronic device as recited in Claim 1 wherein the doped buffer layer has a primary dopant concentration and a background dopant concentration.

3. The optoelectronic device as recited in Claim 1 wherein the doped buffer layer is doped with an N-type dopant having a concentration of at least about 6E15 atoms/cm³.

4. The optoelectronic device as recited in Claim 1 wherein the doped buffer layer comprises indium phosphide.

5. The optoelectronic device as recited in Claim 1 wherein the dopant tail has a P-type dopant concentration of at least about 5E15 atoms/cm³.

6. The optoelectronic device as recited in Claim 1 wherein the absorber layer comprises indium gallium arsenide.

7. The optoelectronic device as recited in Claim 1 further including a first contact region located over the doped region and a second contact region located adjacent the optical window.

8. The optoelectronic device as recited in Claim 1 wherein an optoelectronic device capacitance is less than about .75 picofarad.

9. A method of manufacturing an optoelectronic device, comprising:
augmenting a quantum efficiency, augmenting a bandwidth, and augmenting an optical power level that is acceptable without bandwidth collapse in an optoelectronic device by adjusting dopant concentrations of a doped buffer layer located over a substrate having an optical window formed therein, and a dopant tail located substantially through an absorber layer located over the doped buffer layer.

10. The method as recited in Claim 9 wherein adjusting dopant concentrations of a doped buffer layer includes adjusting dopant concentrations of a doped buffer layer having a primary dopant concentration and a background dopant concentration.

11. The method as recited in Claim 9 wherein adjusting dopant concentrations of a doped buffer layer includes adjusting dopant concentrations of a doped buffer layer using an N-type dopant concentration of at least about 6E15 atoms/cm³.

12. The method as recited in Claim 9 wherein the doped buffer layer comprises indium gallium arsenide.

13. The method as recited in Claim 9 wherein adjusting dopant concentrations of a dopant tail includes adjusting dopant concentrations of a dopant tail using a P-type dopant concentration of at least about 5E15 atoms/cm³.

14. The method as recited in Claim 9 wherein the absorber layer comprises indium gallium arsenide.

15. The method as recited in Claim 9 wherein adjusting dopant concentrations of a dopant tail includes adjusting dopant concentrations of a dopant tail using an ampoule diffusion process.

16. The method as recited in Claim 9 wherein adjusting the dopant concentration of the doped buffer layer includes adjusting the dopant concentration of the doped buffer layer to provide an optoelectronic device capacitance of less than about .75 picofarad.

17. An optical fiber communications system, comprising:
an optoelectronic device, including;
a doped buffer layer located over a substrate having an optical window formed therein;
an absorber layer located over the doped buffer layer; and
a doped region located over the absorber layer and having a dopant tail that extends substantially through the absorber layer, the doped buffer layer and the dopant tail being doped to augment an optical power threshold for bandwidth collapse of the optoelectronic device; and
an optical fiber configured to provide a wavelength of light to the optical window.

18. The optical fiber communications system as recited in Claim 17 wherein the doped buffer layer is doped with an N-type dopant having a concentration of at least about 6E15 atoms/cm³.

19. The optical fiber communications system as recited in Claim 17 wherein the dopant tail has a P-type dopant concentration of at least about 5E15 atoms/cm³.

20. The optical fiber communications system as recited in Claim 17 further including devices selected from the group consisting of:
lasers,
modulators,
optical amplifiers, and
optical waveguides.
